# FASCICULE DE BREVET EUROPEEN

(11) **EP 0 648 375 B1**
(45) Date de publication et mention de la délivrance du brevet: **15.12.1999**
(21) Numéro de dépôt: 93914792.2
(22) Date de dépôt: 01.07.1993
(51) Int. Cl.: H01L 27/115, H01L 21/8247

(54) **MEMOIRE EEPROM DE TYPE FLASH A TRIPLES GRILLES ET SON PROCEDE DE FABRICATION**
FLASH-EEPROM-SPEICHER MIT DREI GATEELEKTRODEN UND SEIN HERSTELLUNGSVERFAHREN.
TRIPLE-GATE FLASH EEPROM MEMORY AND METHOD FOR MAKING SAME

(30) Priorité: 03.07.1992 FR 9208231
(43) Date de publication de la demande: 19.04.1995
(73) Titulaire: COMMISSARIAT A L'ENERGIE ATOMIQUE, 75752 Paris Cédex 15 (FR)
(72) Inventeur: HARTMANN, Joel, F-38640 Claix (FR)
(74) Mandataire: Dubois-Chabert, Guy
(86) Numéro de dépôt international: FR9300667
(87) Numéro de publication internationale: WO9401892

(56) Documents cités:
- EP-A- 47 153
- EP-A- 320 231
- EP-A- 349 774
- EP-A- 419 663
- EP-A- 430 426
- 20TH EUROPEAN SOLID STATE DEVICE RESEARCH CONFERENCE vol. 20, 10 Septembre 1990, NOTTINGHAM,GB pages 177 - 180 AMIN 'A novel Flash EEPROM memory cell with asperities aided erase'
- PATENT ABSTRACTS OF JAPAN vol. 11, no. 83 (E-489)(2530) 13 Mars 1987 & JP-A-61 239 671 ( TOSHIBA CORP. ) 24 Octobre 1986

## Description

La présente invention a pour objet une mémoire EEPROM intégrée, c'est-à-dire une mémoire à lecture seule, programmable et effaçable électriquement par bloc, ainsi que son procédé de fabrication. Cette mémoire est du type flash.

L'invention s'applique en particulier dans le domaine de la fabrication des circuits de mémoire intégrés du type MOS ou du type CMOS à grandes densités d'intégration.

Une mémoire EEPROM intégrée est un circuit intégré comportant une partie mémoire proprement dite formée d'une matrice de plusieurs points mémoires ou cellules mémoires connectés électriquement entre eux et des circuits périphériques servant à commander ces points mémoires.

L'invention a trait uniquement à la partie mémoire proprement dite.

Le concept de mémoire EEPROM flash a été introduit la première fois en 1984 par Toshiba qui proposait une structure à triples grilles, une grille flottante, une grille de contrôle pour la programmation et la lecture et une grille d'effacement réalisées en silicium polycristallin. Cette mémoire était de grande dimension et présentait, pour des règles de dessin (ou largeur de grille flottante) de 2µm, des points mémoires de 64µm² de surface. Cette structure fut très vite abandonnée car elle ne permettait pas de viser de grandes dimensions d'intégration, c'est-à-dire la mémorisation d'au moins 10⁶ éléments binaires, avec des règles de dessin submicroniques.

L'évolution majeure du concept de mémoire flash dont l'intérêt principal est de viser de grandes capacités mémoires pour remplacer les àisques durs ou les disquettes dans les micro-ordinateurs personnels, a été apportée par Intel en 1988 avec l'introduction de la cellule appelée ETOX qui présente le grand avantage d'être semblable à une cellule EPROM.

Cette cellule est notamment décrite dans le document IEEE Journal of Solid State Circuits, vol. 24, n 5, d'octobre 1989, pp. 1259-1263, "A 90-ns one-million erase/program cycle 1- Mbit flash memory" de V. N. Kynett et al.

Chaque point mémoire ETOX comporte un simple transistor à double grille dont la particularité réside dans l'épaisseur de l'oxyde de grille qui est réduit aux alentours de 10nm pour permettre un effacement par effet tunnel de la grille flottante.

La programmation et la lecture de cette mémoire sont identiques à celles d'une mémoire EPROM. Pour chaque cellule mémoire, l'effacement est réalisé en portant une tension de 12V sur la source du transistor tout en maintenant sa grille de commande à la masse. Les électrons de la grille flottante sont collectés par la source par effet tunnel à travers l'oxyde de grille mince de la cellule. La source étant commune à toutes les cellules du plan mémoire, l'effacement est collectif et toute la mémoire peut être effacée en une seule opération.

Ce dispositif a donc ouvert la voie aux grandes densités d'intégration et de nombreuses sociétés ont également adopté ce concept de cellule mémoire. Cependant, si d'un point de vue densité d'intégration ce concept est très intéressant, il présente de nombreux problèmes d'un point de vue électrique.

En effet, l'emploi d'une tension élevée (12V) sur la source provoque généralement la mise en avalanche de la jonction source-substrat de la cellule, ce qui a pour conséquence d'injecter des trous dans l'oxyde de grille de la cellule et de créer des défauts électriques.

Par ailleurs, le courant important utilisé lors de l'effacement nécessite une alimentation extérieure de 12V, la compatibilité avec une alimentation extérieure du circuit sous 5V n'est donc pas possible.

De plus, l'oxyde de grille étant aminci à 10nm ou moins, tous les effets parasites d'une cellule EPROM sont amplifiés et gênent son fonctionnement. En particulier, le phénomène de conduction parasite des cellules appartenant à la même ligne d'éléments binaires que la cellule que l'on adresse (ou "turn-on" en terminologie anglo-saxonne) est accru, la programmation devient plus difficile et l'écriture d'informations parasites ou "soft- write" est importante.

Enfin, l'oxyde de grille de 10nm environ est soumis à un vieillissement prématuré du fait des électrons chauds injectés du côté du drain pendant la programmation et de l'injection de trous chauds pendant l'effacement du côté de la source. Cet oxyde vieillit donc très vite et il est difficile de tenir 10000 cycles de lecture-écriture avec ce type de cellule mémoire.

Récemment, pour contourner ces problèmes importants, il a été proposé, toujours avec le même type de cellule de mémoire, d'amener une tension négative d'environ -10 à -12V sur la grille flottante pendant l'effacement, ce qui permet de réduire la tension appliquée sur la source à 5V, d'utiliser les circuits de commande correspondants fonctionnant en 5V et de supprimer l'avalanche de la jonction source-substrat.

Une telle technique est notamment décrite dans le document "A new flash E²PROM cell using triple polysilicon technology" de Fujio Masuoka et al., IEDM 1984, pp. 464-467 et dans le document "A 5V-Only 0,6µm flash EEPROM with row decoder scheme in triple-well structure" de Masao Kuriyama et al., IEEE 1992, pp. 152-153.

Cette solution est attrayante d'un point de vue électrique mais pose un problème de conception car il est difficile d'engendrer et de véhiculer une tension négative sur un circuit intégré uniquement alimenté avec 5V ou 0V.

Dans le document EP-A-047 153, il est décrit une mémoire EEPROM à triples grilles dans laquelle la grille d'effacement de chaque cellule mémoire est formée au-dessus de la source et à cheval sur l'empilement de grille de commande et de grille flottante ; elle est isolée de la source par l'oxyde de champ épais (500 nm à 1 µm).

Cette mémoire utilise encore des tensions d'effacement très élevées (20 à 30V) et sa programmation se fait par effet tunnel entre la grille flottante et le substrat par application de fortes tensions positives (20 à 30V) sur la grille de commande. Ce type de programmation nécessite l'emploi d'un transistor de sélection pour chaque cellule (soit deux transistors par cellule) de façon à éviter la programmation parasite de toutes les cellules communes à la même grille de commande.

L'utilisation d'un transistor de sélection ne permet pas l'effacement global (ou flash).

En outre, la taille d'une telle cellule est très importante et interdit des densités d'intégration supérieures à quelques dizaines de kilobits, et ce d'autant que la grille de commande n'est pas auto-alignée par rapport à la grille flottante. Par ailleurs, l'oxyde de champ épais de cette mémoire présente un "bec d'oiseau" important (0,5µm à 1µm de débordement de l'oxyde) empêchant, d'entrée, l'utilisation de ce procédé pour des largeurs de grilles flottantes inférieures à 2µm.

Enfin, la diffusion latérale de la jonction N⁺ sous l'oxyde de champ, jouant le rôle de source, est importante, ce qui va aussi dans le sens de la limitation de la densité d'intégration et rend difficile la programmation conventionnelle par électrons chauds du fait de la fluctuation de la longueur du canal.

L'invention a pour objet une mémoire EEPROM intégrée de type flash et son procédé de fabrication permettant de remédier aux différents inconvénients mentionnés ci-dessus. En particulier, cette mémoire peut être alimentée avec des sources de tension de 5V et donc sans problème électrique au niveau de l'oxyde de grille qui peut rester identique à celui d'une mémoire EPROM conventionnelle, c'est-à-dire supérieure à 10nn, et donc ne présentant pas les effets parasites ci-dessus. En outre, la densité d'intégration de la mémoire EEPROM de l'invention est identique à celle des mémoires EPROM et est donc très grande et son fonctionnement est similaire à celui des mémoires EPROM.

Pour ce faire, l'invention propose une mémoire EEPROM flash à triples grilles réalisée selon une structure en T conventionnelle, sans impact notable sur la densité d'intégration.

On connaît déjà, par EP-A-0 349 774 et par EP-A-0 430 426, des mémoires EEPROM intégrées à triples grilles. On connaît aussi, par EP-A-0 320 231 et par 20th European Solid-State Device Research Conference, vol. 20, pages 177-180, Sept. 1990, des mémoires EEPROM de type flash. On connaît en outre, par Patent Abstracts of Japan, vol. 11, no. 83, Mars 1987 et JP-A-61 239 671, un procédé de fabrication d'une mémoire à semiconducteurs.

De façon plus précise, l'invention a pour objet une mémoire EEPROM intégrée à triples grilles de type flash, conformément à la revendication 1.

Selon l'invention, il est possible d'utiliser des grilles flottantes, de commande et d'effacement en métal (Al et ses alliages, W) en un siliciure d'un métal réfractaire (TiSi₂, TaSi₂, WSi₂) ou de préférence en silicium polycristallin dopé au phosphore (0,5 à 2% en poids), dans le cas particulier d'un substrat en silicium.

Après programmation d'une cellule de mémoire (ou point mémoire) selon l'invention, et injection. d'électrons dans la grille flottante correspondante, on effecture l'effacement en polarisant la grille d'effacement à un potentiel de l'ordre de 10 à 12V. L'épaisseur de l'isolant électrique utilisé entre la grille flottante et la grille d'effacement, est ajustée de façon à permettre le passage des électrons vers cette grille d'effacement par effet tunnel depuis la grille flottante. Ainsi, l'isolant de grille des cellules mémoires peut avoir une épaisseur supérieure à 10nm, contrairement aux mémoires de type ETOX.

Ainsi, le fonctionnement de la mémoire de l'invention en programmation et en lecture est rigoureusement identique à celui d'une mémoire EPROM. Il est donc tout à fait possible de suivre l'évolution de la densité d'intégration des EPROMs pour la mémoire de l'invention (quelques dizaines de Mégabits).

En particulier, le positionnement de la grille d'effacement selon l'invention permet de réaliser l'effacement de la cellule sans augmentation de la surface de celle-ci tout en permettant un effacement collectif de la mémoire (flash).

Par ailleurs, l'utilisation de basses tensions d'effacement (12V) permet d'avoir un isolant mince entre la source et la grille d'effacement de chaque cellule mémoire, et réciproquement, d'épaisseur au plus égale à 40 nm mais supérieure à 10 nm.

L'isolant de grille est généralement un oxyde de silicium, mais il pourrait être en nitrure de silicium ou en oxynitrure de silicium.

Les isolants intergrilles y compris ceux prévus entre les grilles flottantes et les grilles d'effacement peuvent être réalisés en n'importe quel type de matériau isolant comme SiO₂, Si₃N₄, SiOₓN_{y} avec 0<x<2 et 0<y<4/3. En particulier, l'isolant intercalé entre les grilles flottantes et les grilles de commande est un empilement tricouche d'oxyde de silicium, de nitrure de silicium et d'oxyde de silicium, noté généralement ONO.

L'invention a aussi pour objet un procédé de fabrication d'une mémoire EEPROM telle que décrite précédemment.

Selon une première variante de mise en oeuvre, le procédé de l'invention comporte les étapes suivantes :
a) - réalisation des isolations latérales,
b) - réalisation desdits empilements entre les isolations latérales et des bandes conductrices d'application des signaux électriques sur lesdits empilements,
c) - formation d'une couche mince d'isolant électrique sur les zones de sources et de drains et sur les flancs des empilements,
d) - implantation d'ions dans le substrat d'un type de conductivité opposé à celui du substrat pour y former les sources et drains, les empilements servant de masque à cette implantation réalisée à travers la couche mince d'isolant, ainsi que les bandes conductrices d'application des signaux électriques sur les grilles d'effacement,
e) - dépôt d'une couche conductrice sur la couche mince d'isolant,
f) - gravure uniquement de cette couche conductrice pour former les grilles d'effacement au-dessus des sources et en partie à cheval sur les empilements,
g) - isolation de surface de la structure obtenue en f), et
h) - réalisation de trous de contact dans l'isolation de surface pour les sources et drains puis réalisation des bandes conductrices pour appliquer les signaux électriques sur les sources et drains.

Selon une seconde variante de mise en oeuvre du procédé conforme à l'invention, on effectue les étapes suivantes :
A) - réalisation des isolations latérales,
B) - réalisation desdits empilements entre les isolations latérales et des bandes conductrices d'application des signaux électriques sur lesdits empilements,
C) - formation d'une couche mince d'isolant électrique sur les zones de sources et de drains et sur les flancs des empilements,
D) - dépôt d'une couche conductrice sur la couche mince d'isolant,
E) - gravure uniquement de cette couche conductrice pour former les grilles d'effacement au-dessus des zones de sources et en partie à cheval sur les empilements,
F) - implantation d'ions dans le substrat, à travers la couche mince d'isolant et la couche conductrice, pour former les sources et drains ayant un type de conductivité opposé à celui du substrat, les empilements servant de masque à cette implantation, ainsi que les bandes conductrices d'application des signaux électriques sur les grilles d'effacement,
G) - isolation de surface de la structure obtenue en F), et
H) - réalisation de trous de contact dans l'isolation de surface pour les sources et drains puis réalisation des bandes conductrices pour appliquer les signaux électriques sur les sources et drains.

Dans cette seconde variante, il est nécessaire d'utiliser une implantation ionique à plus forte énergie que dans la variante précédente (de l'ordre de 150 à 180keV) pour traverser l'épaisseur des grilles d'effacement. En revanche, cette solution présente un avantage qui réside dans le fait que l'implantation est positionnée automatiquement par rapport aux grilles d'effacement et qu'elle est séparée de l'empilement de grilles ou de la double grille par l'épaisseur de ces grilles d'effacement.

Il est ainsi possible de contrôler le courant de chaque cellule mémoire à l'aide du potentiel appliqué sur cette grille d'effacement qui agit alors comme la grille de commande d'un transistor monogrille de type MIS connecté en série avec chaque cellule de mémoire et permet ainsi de rendre cette dernière insensible aux perçages parasites.

Dans le cas d'un substrat, de grilles flottantes et de commande en silicium, la couche mince d'isolant est obtenue par oxydation thermique du silicium.

D'autres caractéristiques et avantages de l'invention ressortiront mieux de la description qui va suivre, donnée à titre illustratif et non limitatif, en référence aux figures annexées, dans lesquelles :
- la figure 1 est une vue de dessus d'une partie d'une mémoire EEPROM conforme à l'invention montrant la connexion des grilles d'effacement,
- les figures 2a et 2b sont des vues en coupe de la figure 1 respectivement selon la ligne A-A (ou ligne d'éléments binaires) et la ligne B-B (ou ligne de mots),
- les figures 3 à 5 illustrent schématiquement en coupe selon une ligne de mots les différentes étapes de fabrication d'une cellule conforme à l'invention, et
- la figure 6 illustre schématiquement en coupe selon une ligne de mots une variante de mise en oeuvre du procédé conforme à l'invention.

L'invention s'applique aussi bien à un substrat en silicium de type N qu'à un substrat de type P. En outre, les transistors auxquels s'applique l'invention peuvent être de type N ou P. Lors de l'utilisation de structures CMOS, il est nécessaire d'effectuer en début de procédé des caissons de type N ou P suivant la nature du substrat utilisé.

La description qui suit se réfère à l'utilisation d'un substrat en silicium monocristallin de type P et à la réalisation de transistors à canal N dans ce substrat.

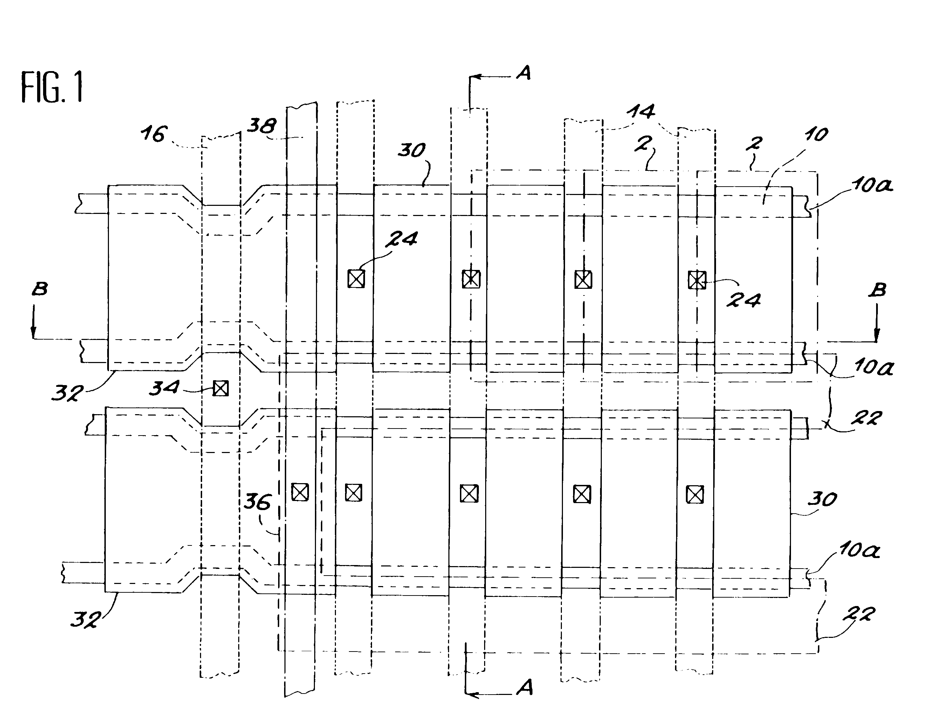

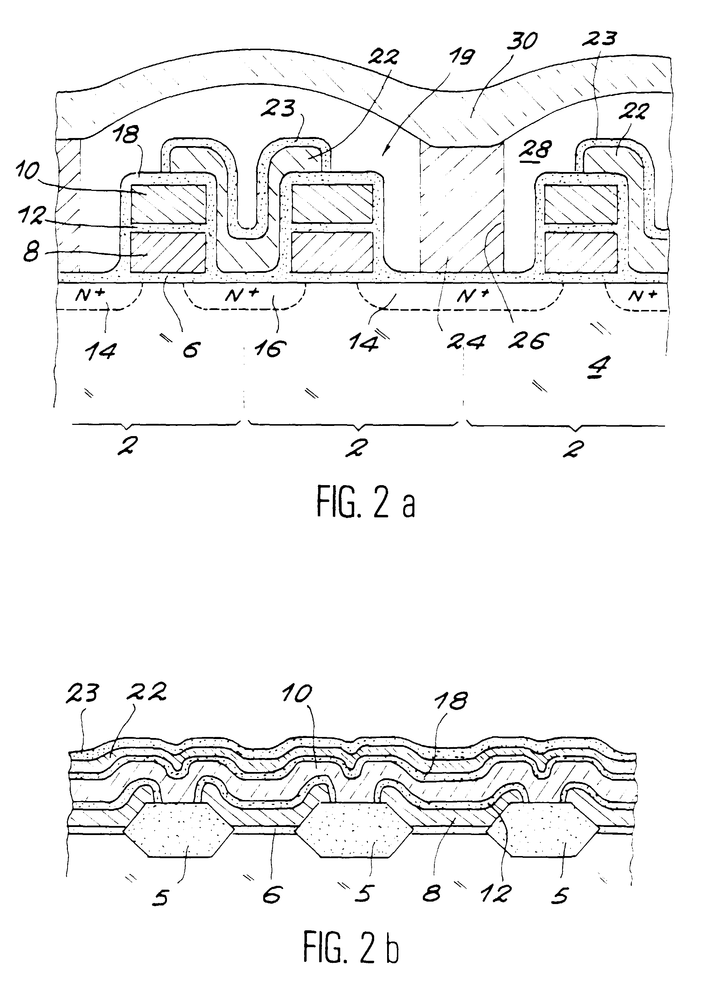

En référence aux figures 1, 2a et 2b, la mémoire EEPROM flash de l'invention comporte des cellules mémoires 2 formées sur un substrat 4 et isolées les unes des autres par un oxyde de champ 5 de type LOCOS.

Chaque cellule de mémoire 2 de l'invention comporte un oxyde de grille 6 typiquement de 20nm, au lieu de 10nm dans le cas d'une mémoire selon l'art antérieur, une grille flottante 8 de 150nm environ réalisée en silicium polycristallin dopé au phosphore, noté poly-1, une grille de commande 10 de 150nm environ en silicium polycristallin dopé au phosphore, noté poly-2, isolée de la grille flottante 8 par un isolant intergrille 12.

Cet isolant 12 est constitué d'un empilement de trois couches, une couche d'oxyde de silicium recouverte d'une fine couche de nitrure de silicium puis d'une fine couche d'oxyde de silicium. L'ensemble est équivalent à une couche de SiO₂ de 20nm d'épaisseur.

De part et d'autre de chaque empilement 19 de grilles et en dehors de l'oxyde de champ 5, on trouve deux zones diffusées dans le substrat 14 et 16, jouant respectivement le rôle de drain et de source, ayant une conductivité N⁺ inverse de celle du substrat P. L'ensemble des empilements de grilles et des sources et drains est recouvert d'une couche d'oxyde mince 18 de 20nm d'épaisseur.

Conformément à l'invention, chaque cellule de mémoire 2 comporte une grille d'effacement 22 réalisée en silicium polycristallin dopé, d'environ 150 à 200nm d'épaisseur, noté poly-3. Chaque grille d'effacement 22 est formée au-dessus de la source 16 du transistor correspondant et est isolée de celle-ci par la couche d'isolant 18. En outre, la grille d'effacement 22 remonte sur le flanc de l'empilement 19 de grilles flottantes et de commande pour se terminer au-dessus de cet empilement. La couche 18 assure alors l'isolement de la grille d'effacement 22 vis-à-vis de la grille flottante 8 et de la grille de commande 10.

Pour deux cellules de mémoire côte-à-côte, les deux grilles d'effacement sont monobloc et forment un U.

Dans ce type de mémoire, chaque source 16 et chaque drain 14 est commun à deux cellules de mémoire adjacentes. Ainsi, chaque cellule 2 comporte un demicontact électrique 24 en métal sur les drains. Chaque contact est constitué d'un plot de tungstène formé dans des ouvertures 26 d'une couche isolante 28 en verre dopé par du bore et du phosphore (BPSG), recouvrant l'ensemble de la mémoire.

Ensuite, on trouve des bandes métalliques 30 parallèles en contact avec les plots 24, destinées à appliquer les tensions nécessaires sur les drains. Ces bandes 30 sont en aluminium et constituent chacune une ligne d'éléments binaires.

Comme représenté sur la figure 1, les grilles de commande 10 des cellules mémoires sont reliées entre elles et constituent en partie des lignes de mots 10a de la mémoire, parallèles entre elles et perpendiculaires aux lignes 30 et réalisées en poly-2. Les tensions de commande à appliquer sur les grilles de commande sont assurées par ces lignes de mots 10a.

Les tensions d'alimentation sont appliquées sur les sources à l'aide de bandes conductrices 32 parallèles, formées au-dessus de la couche isolante 28 dans la même couche métallique que les lignes d'éléments binaires. La couche isolante 28 comporte à cet effet des ouvertures dans lesquelles sont formés des contacts électriques 34 similaires au contact électrique de drain. En général, on trouve une ligne de sources 32 toutes les 16 lignes d'éléments binaires.

Conformément à l'invention, les grilles d'effacement 22 sont toutes reliées électriquement entre elles notamment à l'aide de bandes transversales 36 en poly-3. Une bande conductrice 38 en contact électrique avec les parties transversales 36 assure l'application de la tension d'effacement simultanément sur les grilles 22 d'effacement des cellules de mémoire. Cette bande 38 est réalisée parallèlement aux réalisée aux lignes diffusées 14 de drains et de sources 16 et est réalisée par une ligne diffusée dans le substrat, en même temps que les zones 14 et 16.

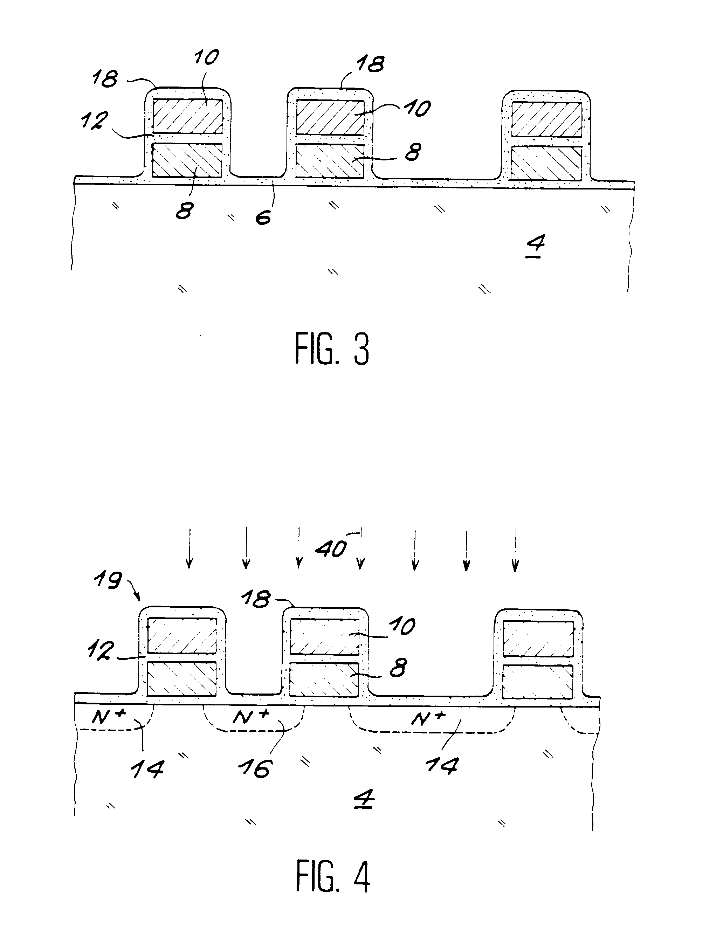

En référence aux figures 3 à 5, on décrit ci-après la fabrication de la mémoire EEPROM flash conforme à l'invention.

Après réalisation de l'isolation de champ 5, on effectue une oxydation thermique du silicium à 1000°C sous oxygène sec pour former l'isolant de grille 6 sur l'ensemble de la structure. On effectue alors l'ajustement de la tension de seuil des cellules de mémoire par implantation ionique de bore à une énergie typique de 30keV et une dose de l'ordre de 10¹²at/cm². On dépose alors le premier niveau de silicium polycristallin par dépôt chimique en phase vapeur basse pression (LPCVD) à 620°C pour réaliser les grilles flottantes 8, suivi d'un dopage par diffusion thermique de POCl₃ à 950°C pendant 30 min.

On effectue alors une gravure du poly-1 pour fixer la longueur des grilles flottantes 8 (mesurée selon le plan de la figure 2b) par un procédé classique de photolithographie en utilisant une gravure ionique réactive (RIE) avec du SF₆.

On réalise alors l'isolant 12 intergrille, entre les grilles flottantes et de commande, en effectuant une oxydation thermique du poly-1, un dépôt de nitrure de silicium par LPCVD à 800°C puis une réoxydation thermique de ce nitrure.

On effectue alors le dépôt de la seconde couche de silicium polycristallin sur l'ensemble de la structure que l'on dope au phosphore comme décrit précédemment.

Une étape de photolithographie définit les grilles de commande 10 des cellules de mémoire dans le poly-2. La gravure de ces grilles de commande est effectuée par RIE avec un mélange de SF₆/Cl₂ pour graver la seconde couche de silicium polycristallin et fixer ainsi la largeur des grilles 10 et des lignes de mots 10a, et un mélange de SF₃ pour graver le diélectrique 12 intergrille. On grave alors les grilles flottantes de manière auto-alignée par rapport aux grilles de commande en utilisant une gravure RIE avec un mélange de HBr/Cl₂ avec arrêt sur l'oxyde de grille 6, et fixer ainsi la largeur des grilles flottantes.

On effectue ensuite une réoxydation de l'ensemble de la structure à 1000°C sous oxygène sec de manière à faire croître l'isolant 18 au-dessus des régions de sources et drains, de l'empilement 19 de grilles et des flancs de cet empilement. La structure obtenue est alors celle représentée sur la figure 3.

On effectue alors, comme représenté sur la figure 4, une implantation ionique 40 pour réaliser les drains 14 et sources 16 des transistors par exemple à l'aide d'arsenic à 80keV pour une dose de 5.10¹⁵at/cm². Cette implantation est réalisée en utilisant les empilements de grilles 19 comme masque. Elle assure en outre la formation des bandes 38 de commande des grilles d'effacement.

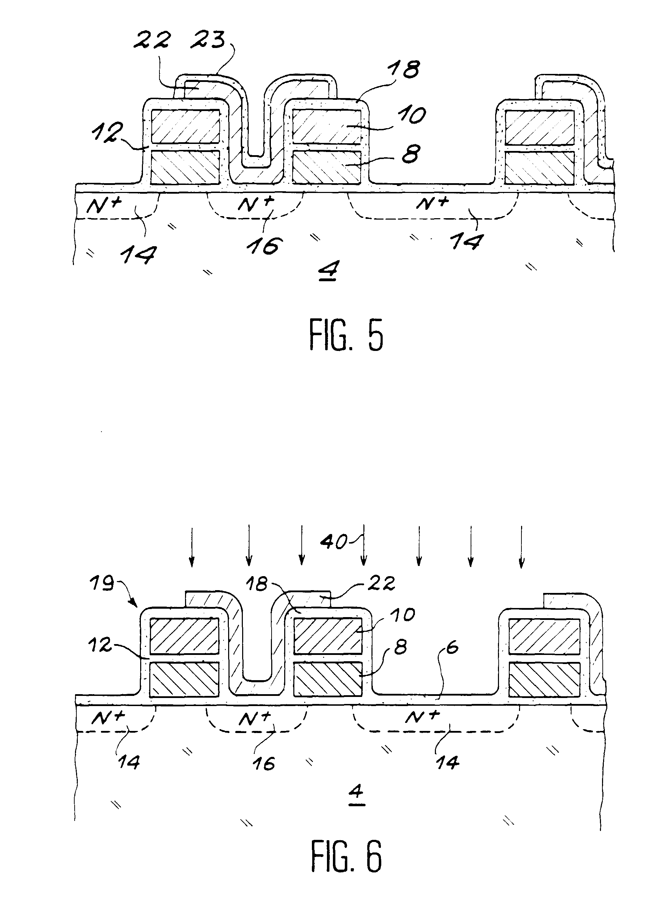

Après activation thermique de cette implantation ionique par exemple à 900°C pendant 30 min sous azote, on effectue, comme représenté sur la figure 5, le dépôt du troisième niveau de silicium polycristallin par LPCVD à 620°C à l'aide de silane. Ce silicium est ensuite dopé par POCl₃ à 950°C.

On réalise ensuite, par photolithographie une gravure de cette troisième couche de silicium polycristallin pour fixer les formes des grilles d'effacement 22. La gravure est effectuée par RIE en utilisant un mélange de chlore et de HBr.

Après réalisation des grilles d'effacement 22, le procédé redevient conventionnel.

La suite du procédé comprend :
- la réoxydation 23 de la troisième grille ainsi formée par oxydation thermique à 950°C sous oxygène sec avec une épaisseur typique sur les flancs du silicium polycristallin de 30nm ;
- le dépôt 28 de verre dopé bore et phosphore par dépôt chimique en phase vapeur à pression atmosphérique (APCVD) avec une épaisseur typique de 700nm ;
- la fluage de ce verre dopé par un traitement thermique à 950°C sous N₂ pendant 30 min ;
- la réalisation des trous de contact 26 et 34 dans la couche 28 par photolithographie et gravure sèche RIE à l'aide de CHF₃ ;
- le dépôt par pulvérisation cathodique sur toute la structure d'une couche d'aluminium avec 1% de silicium, sur une épaisseur typique de 700nm ;
- puis la réalisation des lignes d'éléments binaires 30 et des lignes de sources 32 dans cette couche d'Al-Si par photolithographie et gravure sèche RIE à l'aide de BCl₃.

Enfin, une couche de passivation (non représentée) généralement formée d'un verre dopé phosphore est déposée par APCVD sur une épaisseur typique de 1µm sur toute la structure.

Dans une variante de réalisation représentée sur la figure 6, on dépose puis grave le troisième niveau de silicium polycristallin pour former les grilles d'effacement 22 puis on effectue l'implantation ionique 40 de sources 16 et drains 14 à travers les grilles 22 et l'isolant de grilles, en utilisant les empilements 19 comme masque. La dose d'implantation est la même que précédemment mais l'énergie d'implantation est plus élevée (150 à 180keV).

## Revendications

1. Mémoire EEPROM intégrée à triples grilles de type flash, comportant un substrat semi-conducteur (4), une matrice de cellules mémoires en T (2) isolées électriquement les unes des autres par des isolations latérales (5), formée sur le substrat, dans laquelle chaque cellule mémoire comprend un empilement (19) de grilles constitué d'un isolant de grille (6), d'une grille flottante (8) débordant sur les isolations latérales et d'une grille de commande (10) séparées par un isolant électrique intergrille (12), l'isolant de grille étant interposé entre la grille flottante et le substrat, une source (16) et un drain (14) formés dans le substrat de part et d'autre de cet empilement et en dehors des isolations latérales, la source ayant une direction de conduction perpendiculaire à celle du drain, une grille d'effacement (22) formée au-dessus de la source parallèlement à celle-ci et en partie à cheval sur l'empilement, cette grille d'effacement étant isolée électriquement de la source et des grilles de cet empilement par un isolant mince (18), les grilles d'effacement étant toutes reliées électriquement entre elles, et des bandes conductrices (10a, 38, 30, 32) pour appliquer des signaux électriques respectivement sur les empilements de grilles, les grilles d'effacement, les sources et les drains.

2. Mémoire selon la revendication 1, caractérisée en ce que le substrat étant du silicium, les grilles d'effacement (22) sont réalisées en silicium polycristallin dopé.

3. Mémoire selon la revendication 2, caractérisée en ce que les isolants de grille sont de l'oxyde de silicium d'épaisseur >10nm.

4. Mémoire selon l'une quelconque des revendications 1 à 3, caractérisée en ce que les isolants intergrilles sont en un matériau tricouche d'oxyde, de nitrure et d'oxyde de silicium

5. Mémoire selon l'une quelconque des revendications 1 à 4, caractérisée en ce que l'isolant mince a une épaisseur au plus égale à 40nm.

6. Mémoire selon l'une quelconque des revendications 1 à 5, caractérisée en ce que les bandes conductrices (38) pour appliquer les signaux électriques sur les grilles d'effacement sont des lignes diffusées dans le substrat.

7. Mémoire selon l'une quelconque des revendications précédentes, caractérisée en ce que les grilles flottantes sont auto-alignées par rapport aux grilles de commande.

8. Procédé de fabrication d'une mémoire EEPROM intégrée de type flash selon la revendication 1, comportant un substrat semi-conducteur (4) d'un type donné de conductivité, une matrice de cellules mémoires en T (2) isolées électriquement les unes des autres par des isolations latérales (5), formée sur le substrat, chaque cellule mémoire comprenant un empilement (19) de grilles constitué d'un isolant de grille (6), d'une grille flottante (8) débordant sur les isolations latérales et d'une grille de commande (10) séparées par un isolant électrique intergrille (12), l'isolant de grille étant interposé entre la grille flottante et le substrat, une source (16) et un drain (14) formés dans le substrat de part et d'autre de cet empilement et en dehors des isolations latérales, la source ayant une direction de conduction perpendiculaire à celle du drain, une grille d'effacement (22) étant isolée électriquement de la source et des grilles de cet empilement par un isolant mince (18), les grilles d'effacement étant toutes reliées électriquement entre elles, et des bandes conductrices (10a, 38, 30, 32) pour appliquer des signaux électriques respectivement sur les empilements de grilles, les grilles d'effacement, les sources et les crains, ce procédé comportant les étapes suivantes :
a) - réalisation des isolations iatérales (5),
b) - réalisation desdits empilements (19) entre les isolations latérales et des bandes conductrices (10a) d'application des signaux électriques sur lesdits empilements,
c) - formation d'une couche mince d'isolant électrique (18) sur les zones de sources et de drains et sur les flancs des empilements,
d) - implantation d'ions (40) dans le substrat d'un type de conductivité opposé à celui du substrat pour y former les sources et drains, les empilements servant de masque à cette implantation réalisée à travers la couche mince d'isolant, ainsi que les bandes conductrices (38) d'application des signaux électriques sur les grilles d'effacement,
e) - dépôt d'une couche conductrice (22) sur la couche mince d'isolant,
f) - gravure uniquement de cette couche conductrice pour former les grilles d'effacement au-dessus des sources et en partie à cheval sur les empilements,
g) - isolation de surface (23, 28) de la structure obtenue en f), et
h) - réalisation de trous de contact (26, 34) dans l'isolation de surface pour les sources et drains puis réalisation des bandes conductrices pour appliquer les signaux électriques sur les sources et drains.

9. Procédé de fabrication d'une mémoire EEPROM intégrée du type flash selon la revendication 1, comportant un substrat semi-conducteur (4) d'un type donné de conductivité, une matrice de cellules mémoires en T (2) isolées électriquement les unes des autres par des isolations latérales (5), formée sur le substrat, chaque cellule mémoire comprenant un empilement (19) de grilles constitué d'un isolant de grille (6), d'une grille flottante (8) débordant sur les isolations latérales et d'une grille de commande (10) séparées par un isolant électrique intergrille (12), l'isolant de grille étant interposé entre la grille flottante et le substrat, une source (16) et un drain (14) formés dans le substrat de part et d'autre de cet empilement et en dehors des isolations latérales, la source ayant une direction de conduction perpendiculaire à celle du drain, une grille d'effacement (22) étant isolée électriquement de la source et des grilles de cet empilement par un isolant mince (18), les grilles d'effacement étant toutes reliées électriquement entre elles, et des bandes conductrices (10a, 38, 30, 32) pour appliquer des signaux électriques respectivement sur les empilements de grilles, les grilles d'effacement, les sources et les drains, ce procédé comportant les étapes suivantes :
A) - réalisation des isolations latérales (5),
B) - réalisation desdits empilements (19) entre les isolations latérales et des bandes conductrices (10a) d'application des signaux électriques sur lesdits empilements,
C) - formation d'une couche mince d'isolant électrique (18) sur les zones de sources et de drains et sur les flancs des empilements,
D) - dépôt d'une couche conductrice (22) sur la couche mince d'isolant,
E) - gravure uniquement de cette couche conductrice pour former les grilles d'effacement au-dessus des zones de sources et en partie à cheval sur les empilements,
F) - implantation d'ions (40) dans le substrat, à travers la couche mince d'isolant et la couche conductrice, pour former les sources et drains ayant un type de conductivité opposé à celui du substrat, les empilements servant de masque à cette implantation, ainsi que les bandes conductrices (38) d'application des signaux électriques sur les grilles d'effacement,
G) - isolation de surface (23, 28) de la structure obtenue en F), et.
H) - réalisation de trous de contact (26, 34) dans l'isolation de surface pour les sources et drains puis réalisation des bandes conductrices pour appliquer les signaux électriques sur les sources et drains.

10. Procédé selon la revendication 8 ou 9, caractérisé en ce que le substrat étant du silicium, les grilles d'effacement (22) sont réalisées en silicium polycristallin dopé.

11. Procédé selon l'une quelconque des revendications 8 à 10, caractérisé en ce que le substrat, les grilles flottantes et de commande étant en silicium, la couche mince d'isolant est obtenue par oxydation thermique du silicium.

12. Procédé selon l'une quelconque des revendications 8 à 11, caractérisé en ce que la couche mince d'isolant (18) a une épaisseur au plus égale à 40nm.

13. Procédé selon la revendication 10, caractérisé en ce qu'on isole les grilles d'effacement (22) par oxydation thermique de ces grilles d'effacement.

14. Procédé selon l'une quelconque des revendications 8 à 13, caractérisé en ce que les grilles flottantes sont auto-alignées par rapport aux grilles de commande.

## Claims

1. Triple gate integrated EEPROM memory of the flash type including a semiconductor substrate (4), an array of memory cells in T (2) electrically insulated from one another by lateral insulations (5) formed on the substrate, wherein each memory cell includes a stack (19) of gates constituted by a gate insulator (6), a floating gate (8) projecting over the lateral insulations and a control gate (10) separated by an inter-gate electrical insulator (12), the gate insulator being interposed between the floating gate and the substrate, a source (16) and a drain (14) formed in the substrate on either side of said stack and outside the lateral insulations, the source having a conduction direction perpendicular to that of the drain, an erasing gate (22) formed above the source parallel thereto, and partly astride the stack, said erasing gate being electrically insulated from the source and the gates of said stack by a thin insulator (18), the erasing gates being all electrically interconnected, and conductive strips (10a, 38, 30, 32) for applying electrical signals respectively to the stacks of gates, the erasing gates, the sources and the drains.

2. Memory according to claim 1, characterized in that as the substrate is of silicon, the erasing gates (22) are made from doped polycrystalline silicon.

3. Memory according to claim 2, characterized in that the gate insulators are of >10 nm thick silicon dioxide.

4. Memory according to any one of the claims 1 to 3, characterized in that the inter-gate insulators are of a three-layer oxide, nitride and silicon dioxide material.

5. Memory according to any one of the claims 1 to 4, characterized in that the thin insulator has a thickness at the most equal to 40 nm.

6. Memory according to any one of the claims 1 to 5, characterized in that the conductive strips (38) for applying the electrical signals to the erasing gates are lines diffused in the substrate.

7. Memory according to any one of the preceding claims, characterized in that the floating gates are self-aligned relative to the control gates.

8. Process for the production of a triple gate integrated EEPROM memory of the flash type according to claim 1, including a semiconductor substrate (4), an array of memory cells (2) electrically insulated from one another by lateral insulations (5) formed on the substrate, each memory cell including a stack (19) of gates constituted by a gate insulator (6), a floating gate (8) projecting over the lateral insulations and a control gate (10) separated by an inter-gate electrical insulator (12), the gate insulator being interposed between the floating gate and the substrate, a source (16) and a drain (14) formed in the substrate on either side of said stack and outside the lateral insulations, the source having a conducting direction perpendicular to that of the drain, an erasing gate (22) formed above the source and partly astride the stack, said erasing gate being electrically insulated from the source and the gates of said stack by a thin insulator (18), the erasing gates being all electrically interconnected, and conductive strips (10a, 38, 30, 32) for applying electrical signals respectively to the stacks of gates, the erasing gates, the sources and the drains, this process comprising the following stages:
a) producing lateral insulations (5),
b) producing said stacks (19) between the lateral insulations and the conductive strips (10a) for the application of electrical signals to said stacks,
c) formation of a thin electrical insulator layer (18) on the source and drain areas and on the flanks of the stacks,
d) implantation of ions (40) in the substrate of a conductivity type opposite to that of the substrate in order to form therein the sources and drains, the stacks serving as a mask to said implantation performed through the thin insulator layer, as well as the conductive strips (38) for the application of electrical signals to the erasing gates,
e) deposition of a conductive layer (22) on the thin insulator layer,
f) etching solely of said conductive layer in order to form erasing gates above the sources and partly astride the stacks,
g) insulation of the surface (23, 28) of the structure obtained in f), and
h) producing contact holes (26, 34) in the surface insulation for the sources and drains and then producing conductive strips for applying electrical signals to the sources and drains.

9. Process for the production of a triple gate integrated EEPROM memory of the flash type according to claim 1, including a semiconductor substrate (4), an array of memory cells (2) electrically insulated from one another by lateral insulations formed on the substrate, each memory cell including a stack (19) of gates constituted by a gate insulator (6), a floating gate (8) projecting over the lateral insulations and a control gate (10) separated by an inter-gate electrical insulator (12), the gate insulator being interposed between the floating gate and the substrate, a source (16) and a drain (14) formed in the substrate on either side of said stack and outside the lateral insulations, the source having a conducting direction perpendicular to that of the drain, an erasing gate (22) formed above the source and partly astride the stack, said erasing gate being electrically insulated from the source and the gates of said stack by a thin insulator (18), the erasing gates being all electrically interconnected, and conductive strips (10a, 38, 30, 32) for applying electrical signals respectively to the stacks of gates, the erasing gates, the sources and the drains, this process comprising the following stages:
A) producing lateral insulations (5),
B) producing said stacks (19) between the lateral insulations and the conductive strips (10a) for applying electrical signals to said stacks,
C) formation of a thin electrical insulator layer (18) on the source and drain areas and on the flanks of the stacks,
D) deposition of a conductive layer (22) on the thin insulator layer,
E) etching solely of said conductive layer in order to form erasing gates above the source areas and partly astride the stacks,
F) implantation of ions (40) in the substrate through the thin insulator layer and conductive layer, in order to form the sources and drains having a conductivity type opposite to that of the substrate, the stacks serving as a mask to said implantation, as well as the conductive strips (38) for the application of electrical signals to the erasing gates,
G) surface insulation (23, 28) of the structure obtained in F), and
H) producing contact holes (26, 34) in the surface insulation for the sources and drains and then producing conductive strips for applying the electrical signals to the sources and drains.

10. Process according to claim 8 or 9, characterized in that as the substrate is of silicon, the erasing gates (22) are made from doped polycrystalline silicon.

11. Process according to any one of the claims 8 to 10, characterized in that the substrate, the floating and control gates are of silicon, so that the thin insulating layer is obtained by thermal oxidation of silicon.

12. Process according to any one of the claims 8 to 11, characterized in that the thin insulating layer (18) has a thickness at the most equalto 40 nm.

13. Process according to claim 10, characterized in that the erasing gates (22) are insulated by the thermal oxidation of said erasing gates.

14. Process according to any one of the claims 8 to 13, characterized in that the floating gates are self-aligned relative to the control gates.

## Patentansprüche

1. Integrierter Flash-EEPROM-Speicher mit drei Gateelektroden, umfassend ein Halbleitersubstrat (4) und eine T-förmige Matrix von elektrisch durch auf dem Substrat gebildete seitliche Isolationen (5) voneinander isolierten Speicherzellen (2), wobei jede Speicherzelle einen Gate-Stapel (19) enthält, gebildet durch einen Gate-Isolator (6), ein über die seitlichen Isolationen ragendes floatendes Gate (8) und ein Steuergate (10), getrennt durch einen elektrischen Zwischengate-Isolator (12), wobei der Gate-Isolator eingefügte ist zwischen das floatende Gate und das Substrat, eine Source (16) und einen Drain (14), gebildet in dem Substrat auf beiden Seiten dieses Gate-Stapels und außerhalb der seitlichen Isolationen, wobei die Source eine Leitungsrichtung senkrecht zu der des Drains aufweist, ein Lösch-Gate (22), ausgebildet über der Source und parallel zu dieser und den Stapel teilweise überlappend, wobei dieses Lösch-Gate von der Source und den Gates dieses Stapels elektrisch durch einen dünnen Isolator (18) isoliert ist und die Lösch-Gates alle elektrisch miteinander verbunden sind, und leitfähige Streifen (10a, 38, 30, 32), um elektrische Signale jeweils an die Gate-Stapel, die Lösch-Gates, die Sources und die Drains zu legen.

2. Speicher nach Anspruch 1, dadurch gekennzeichnet, daß das Substrat aus Silicum ist und die Lösch-Gates (22) aus dotiertem polykristallinem Silicium sind.

3. Speicher nach Anspruch 2, dadurch gekennzeichnet, daß die Gate-Isolatoren aus Siliciumoxid mit einer Dicke von >10nm sind.

4. Speicher nach einem der Ansprüche 1 bis 3, dadurch gekennzeichnet, daß die Zwischengate-Isolatoren aus einem dreischichtigen Material aus Siliciumoxid, -nitrid und -oxid sind.

5. Speicher nach einem der Ansprüche 1 bis 4, dadurch gekennzeichnet, daß der dünne Isolator eine Dicke von höchstens 40nm hat.

6. Speicher nach einem der Ansprüche 1 bis 5, dadurch gekennzeichnet, daß die leitenden Streifen (38) zum Anlegen der elektrischen Signale an die Lösch-Gates in das Substrat diffundierte Zeilen sind.

7. Speicher nach einem der vorangehenden Ansprüche, dadurch gekennzeichnet, daß die floatenden Gates in bezug auf die Steuergates selbstjustiert sind.

8. Verfahren zur Herstellung eines integrierten Flash-EEPROM-Speichers nach Anspruch 1, umfassend ein Halbleitersubstrat (4) eines bestimmten Konduktivitätstyps, eine T-förmige Matrix aus elektrisch durch auf dem Substrat gebildete seitliche Isolationen (5) voneinander isolierten Speicherzellen (2) , wobei jede Speicherzelle einen Gate-Stapel (19) enthält, gebildet durch einen Gate-Isolator (6), ein über die seitlichen Isolationen ragendes floatendes Gate (8) und ein Steuergate (10), getrennt durch einen elektrischen Zwischengate-Isolator (12), wobei der Gate-Isolator eingefügt ist zwischen das floatende Gate und das Substrat, eine Source (16) und einen Drain (14), gebildet in dem Substrat auf beiden Seiten dieses Gate-Stapels und außerhalb der seitlichen Isolationen, wobei die Source eine Leitungsrichtung senkrecht zu der des Drains aufweist, ein Lösch-Gate (22), das von der Source und den Gates dicscs Stapels elektrisch durch einen dünnen Isolator (18) isoliert ist, wobei die Lösch-Gates alle elektrisch miteinander verbunden sind, und leitfähige Streifen (10a, 38, 30, 32), um elektrische Signale jeweils an die Gate-Stapel, die Lösch-Gates, die Sources und die Drains zu legen, wobei dieses Verfahren die folgenden Schritte umfaßt:
a) - Erzeugen der seitlichen Isolationen (5),
b) - Erzeugen der genannten Stapel (19) zwischen den seitlichen Isolationen und den leitfähigen Streifen (10a) zum Anlegen der elektrischen Signale an die genannten Stapel,
c) - Bilden einer dünnen elektrischen Isolatorschicht (18) auf den Sources- und Drains-Zonen und auf den Flanken der Stapel,
d) - Ionenimplantation (40) in das Substrat mit einem entgegengesetzten Konduktivitätstyps in bezug auf den des Substrats, um dort die Sources und Drains zu bilden, wobei die Stapel bei dieser Implantation, ausgeführt durch die dünne Isolatatorschicht, als Maske dienen, sowie die leitfähigen Streifen (38) zum Anlegen der elektrischen Signale an die Lösch-Gates,
e) - Abscheiden einer leitfähigen Schicht (22) auf der dünnen Isolatorschicht,
f) - Ätzen von ausschließlich dieser leitfähigen Schicht, um über den Sources die die Stapel teilweise überlappenden Lösch-Gates zu bilden,
g) - Oberflächenisolation (23, 28) der in f) erzeugten Struktur, und
h) - Herstellen der Kontaktlöcher (26, 34) in der Oberflachenisolation für die Sources und Drains, dann Herstellen der leitfähigen Streifen zum Anlegen der elektrischen Signale an die Sources und Drains.

9. Verfahren zur Herstellung eines integrierten Flash-EEPROM-Speichers nach Anspruch 1, umfassend ein Halbleitersubstrat (4) eines bestimmten Konduktivitätstyps, eine T-förmige Matrix aus elektrisch durch auf dem Substrat gebildete seitliche Isolationen (5) voneinander isolierten Speicherzellen (2) , wobei jede Speicherzelle einen Gate-Stapel (19) enthält, gebildet durch einen Gate-Isolator (6), ein über die seitlichen isolationen ragendes floatendes Gate (8) und ein Steuergate (10), getrennt durch einen elektrischen Zwischengate-Isolator (12), wobei der Gate-Isolator eingefügt ist zwischen das floatende Gate und das Substrat, eine Source (16) und einen Drain (14), gebildet in dem Substrat auf beiden Seiten dieses Gate-Stapels und außerhalb der seitlichen Isolationen, wobei die Source eine Leitungsrichtung senkrecht zu der des Drains aufweist, ein Lösch-Gate (22), das von der Source und den Gates dieses Stapels elektrisch durch einen dünnen Isolator (18) isoliert ist, wobei die Lösch-Gates alle elektrisch miteinander verbunden sind, und leitfähige Streifen (10a, 38, 30, 32), um elektrische Signale jeweils an die Gate-Stapel, die Lösch-Gates, die Sources und die Drains zu legen, wobei dieses Verfahren die folgenden Schritte umfaßt:
A) - Erzeugen der seitlichen Isolationen (5),
B) - Erzeugen der genannten Stapel (19) zwischen den seitlichen Isolationen und den leitfähigen Streifen (10a) zum Anlegen der elektrischen Signale an die genannten Stapel,
C) - Bilden einer dünnen elektrischen Isolatorschicht (18) auf den Sources- und Drains-Zonen und auf den Flanken der stapel,
D) - Abscheiden einer leitfähigen Schicht (22) auf der dünnen Isolatorschicht,
E) - Ätzen von ausschließlich dieser leitfähigen Schicht, um über den Sources die die Stapel teilweise überlappenden Lösch-Gates zu bilden,
F) - Ionenimplantation (40) in das Substrat mit einem entgegengesetzten Konduktivitätstyps in bezug auf den des Substrats, um dort die Sources und Drains zu bilden, wobei die Stapel bei dieser Implantation, ausgeführt durch die dünne Isolacatorschicht, als Maske dienen, sowie die leitfähigen Streifen (38) zum Anlegen der elektrischen Signale an die Lösch-Gates,
G) - Oberflächenisolation (23, 28) der in F) erzeugten Struktur, und
H) - Herstellen der Kontaktlöcher (26, 34) in der Oberflächenisolation für die Sources und Drains, dann Herstellen der leitfähigen Streifen zum Anlegen der elektrischen Signale an die Sources und Drains.

10. Verfahren nach Anspruch à oder 9, dadurch gekennzeichnet, daß das Substrat aus Silicium besteht, wobei die Lösch-Gates (22) aus dotiertem polikristallinem Silicium hergestellt sind.

11. Speicher nach Anspruch 8 bis 10, dadurch gekennzeichnet, daß das Substrat, die floatenden Gates und die Steuergates aus Silicium sind und die dünne Isolatorschicht durch thermische Oxidation des Siliciums erzeugt wird.

12. Speicher nach einem der Ansprüche 8 bis 11, dadurch gekennzeichnet, daß die dünne Isolatorschicht (18) eine Dicke von höchstens 40nm hat.

13. Speicher nach Anspruch 10, dadurch gekennzeichnet, daß man die Lösch-Gates (22) durch thermische Oxidation dieser Lösch-Gates isoliert.

14. Speicher nach einem der Ansprüche 8 bis 13, dadurch gekennzeichnet, daß die floatenden Gates in bezug auf die Steuergates selbstjustiert sind.
